# EUROPEAN PATENT APPLICATION

(11) **EP 2 112 209 A1**
(43) Date of publication of application: **28.10.2009**
(21) Application number: 09005479.2
(22) Date of filing: 17.04.2009
(51) Int. Cl.: C09J 7/02

(54) **Thermosetting adhesive or pressure-sensitive adhesive tape or sheet**

(30) Priority: 21.04.2008 JP 2008110630
(71) Applicant: NITTO DENKO CORPORATION, Osaka (JP)
(72) Inventor: Nonaka, Takahiro, Ibaraki-shi, Osaka (JP); Daigaku, Noritsugu, Ibaraki-shi, Osaka (JP); Kuwahara, Rie, Ibaraki-shi, Osaka (JP); Oura, Masahiro, Ibaraki-shi, Osaka (JP); Sutou, Sadaji, Ibaraki-shi, Osaka (JP)
(74) Representative: Grünecker, Kinkeldey, Stockmair & Schwanhäusser Anwaltssozietät

(57) **Abstract**

The present invention provides a thermosetting adhesive or pressure-sensitive adhesive tape or sheet including: a thermosetting adhesive or pressure-sensitive adhesive layer formed of a thermosetting adhesive or pressure-sensitive adhesive composition containing an acrylic polymer (X) constituted of, as essential monomer components, an alkyl (meth)acrylate (a) in which the alkyl moiety thereof has from 2 to 14 carbon atoms and a cyano group-containing monomer (b), and a phenol resin (Y); and provided on at least one surface of the thermosetting adhesive or pressure-sensitive adhesive layer, a release liner including a plastic film substrate and a release layer provided on at least one side of the plastic film substrate, the release layer containing low density polyethylene as a major component and having a thickness of 5 µm or more and less than 20 µm.

## Description

### FIELD OF THE INVENTION

The present invention relates to a thermosetting adhesive or pressure-sensitive adhesive tape or sheet. In more detail, the invention relates to a thermosetting adhesive or pressure-sensitive adhesive tape or sheet which can be suitably used in flexible printing circuit boards and the like.

### BACKGROUND OF THE INVENTION

In electronic instruments, flexible printing circuit boards (sometimes referred to as "FPC") have been widely utilized. In such an FPC, an adhesive is used in (1) a step of adhering and laminating a conductive metal foil (for example, a copper foil, an aluminum foil, etc.) on a heat-resistant substrate (for example, a polyimide-made substrate, a polyamide-made substrate, etc.) to prepare FPC, or (2) a step of adhering FPC to a reinforcing plate (for example, an aluminum plate, a stainless steel plate, a polyimide plate, etc.).

As the adhesive to be used in adhesion of such FPC, there have hitherto been widely utilized nitrile rubber (NBR)/epoxy resin based adhesives, acrylic rubber/epoxy resin based adhesives and acrylic rubber/phenol resin based adhesives (see Patent Documents 1 and 2). However, in these adhesives, there was encountered a problem that the storage stability (stability with time) as an adhesive is low. Also, in the case of FPC to be used for applications of precision electronic parts (instruments), in order to prevent contact failure from occurring, adhesive tapes or sheets from which a silicone based material has been excluded were demanded.

Then, with respect to such problems, as a thermosetting adhesive or pressure-sensitive adhesive tape or sheet which has good stability with time of an adhesive and which does not substantially use a silicone based material, there is known a thermosetting adhesive or pressure-sensitive adhesive tape or sheet having a structure in which a thermosetting adhesive or pressure-sensitive adhesive layer made of a thermosetting adhesive or pressure-sensitive adhesive composition containing an acrylic polymer constituted of, as monomer components, a specified alkyl (meth)acrylate and a cyano group-containing monomer and a phenol resin is protected by a release liner having a release layer of polyethylene and the like, in which a silicone component is not substantially contained (see Patent Document 3).

However, in the foregoing thermosetting adhesive or pressure-sensitive adhesive tape or sheet, paper based substrates were in general used as a substrate of the release liner from the viewpoint of, for example, costs. Thus, there were involved problems such as the generation of a paper dust in a manufacturing or processing step or the like. Also, in the case where a release liner which is used in usual pressure-sensitive adhesive tapes is applied to a thermosetting adhesive or pressure-sensitive adhesive tape, the releasability is not appropriate due to a difference in tackiness (pressure-sensitive adhesiveness) on the surfaces. Thus, when a release force is too small, problems such as falling-off or "unintended separation" (phenomenon in which peeling occurs not at a predetermined interface but occurs at another unintended interface) of the release liner were caused. On the other hand, when a release force is too large, problems such as separation of the adhesive or pressure-sensitive adhesive layer or a reduction of release workability were caused. Furthermore, there was caused a problem in processability such as easy generation of a burr during half-cutting of the adhesive or pressure-sensitive adhesive tape or sheet.
Patent Document 1 : U.S. Patent No. 3,822,175
Patent Document 2 : U.S. Patent No. 3,900,662
Patent Document 3 : JP-A-2005-247910

### SUMMARY OF THE INVENTION

Accordingly, an object of the invention is to provide an excellent thermosetting adhesive or pressure-sensitive adhesive tape or sheet having a thermosetting adhesive or pressure-sensitive adhesive layer with good stability with time and made of a specified acrylic polymer and a phenol resin, which is inhibited with respect to the generation of a paper dust in a manufacturing or processing step and improved with respect to releasability and processability.

In order to achieve the foregoing object, the present inventors have made extensive and intensive investigations. As a result, it has been found that a thermosetting adhesive or pressure-sensitive adhesive tape or sheet which is inhibited with respect to the generation of a paper dust in a manufacturing or processing step and which is excellent in releasability and processability is obtained by using, as a thermosetting adhesive or pressure-sensitive adhesive composition for forming a thermosetting adhesive or pressure-sensitive adhesive layer in a thermosetting adhesive or pressure-sensitive adhesive tape or sheet, a thermosetting adhesive or pressure-sensitive adhesive composition having a specified acrylic polymer combined with a phenol resin and providing a release liner including a low density polyethylene release layer having a specified thickness provided on a plastic film substrate on the thermosetting adhesive or pressure-sensitive adhesive layer. The invention has been accomplished on the basis of these findings.

Specifically, the invention provides the following items 1 to 8.
1. A thermosetting adhesive or pressure-sensitive adhesive tape or sheet comprising:
   a thermosetting adhesive or pressure-sensitive adhesive layer formed of a thermosetting adhesive or pressure-sensitive adhesive composition containing an acrylic polymer (X) constituted of, as essential monomer components, an alkyl (meth)acrylate (a) in which the alkyl moiety thereof has from 2 to 14 carbon atoms and a cyano group-containing monomer (b), and a phenol resin (Y); and
   provided on at least one surface of the thermosetting adhesive or pressure-sensitive adhesive layer, a release liner comprising a plastic film substrate and a release layer provided on at least one side of the plastic film substrate, the release layer containing low density polyethylene as a major component and having a thickness of 5 µm or more and less than 20 µm.
2. The thermosetting adhesive or pressure-sensitive adhesive tape or sheet according to item 1, wherein the low density polyethylene has a density of from 0.910 to 0.920 g/cm³.
3. The thermosetting adhesive or pressure-sensitive adhesive tape or sheet according to item 1 or 2, which is a thermosetting adhesive or pressure-sensitive adhesive tape or sheet in which both surfaces of an adhesive or pressure-sensitive adhesive body portion are adhesive surfaces,
   wherein a first release liner is provided on one adhesive surface and a second release liner is provided on the other adhesive surface, and
   wherein at least one of the first and second release liners is the release liner according to item 1 or 2.
4. The thermosetting adhesive or pressure-sensitive adhesive tape or sheet according to item 3, which is a thermosetting adhesive or pressure-sensitive adhesive tape or sheet in which both surfaces of an adhesive or pressure-sensitive adhesive body portion are adhesive surfaces,
   wherein a first release liner is provided on one adhesive surface and a second release liner is provided on the other adhesive surface, and
   wherein one of the first and second release liners is the release liner according to item 1 or 2, and the other one of the first and second release liners is a release liner comprising a release layer containing linear low density polyethylene as an essential component.
5. The thermosetting adhesive or pressure-sensitive adhesive tape or sheet according to item 1 or 2, which is a thermosetting adhesive or pressure-sensitive adhesive tape or sheet in which both surfaces of an adhesive or pressure-sensitive adhesive body portion are adhesive surfaces,
   wherein a release liner is provided only on one adhesive surface, and the release liner is the release liner according to item 1 or 2 comprising release layers on both sides of the plastic film substrate.
6. The thermosetting adhesive or pressure-sensitive adhesive tape or sheet according to item 5, wherein the release liner according to item 1 or 2 comprises:
   the plastic film substrate,
   the release layer containing low density polyethylene as a major component and having a thickness of 5 µm or more and less than 20 µm, the release layer being provided on one side of the plastic film substrate; and
   another release layer containing linear low density polyethylene as an essential component and being disposed on the other side of the plastic film substrate.
7. The thermosetting adhesive or pressure-sensitive adhesive tape or sheet according to any one of items 1 to 6, wherein the release liner according to item 1 or 2 is colored.
8. The thermosetting adhesive or pressure-sensitive adhesive tape or sheet according to any one of items 1 to 7, which is for use in adhesion with respect to a flexible printing circuit board.

According to the thermosetting adhesive or pressure-sensitive adhesive tape or sheet of the invention, owing the forgoing constitution of the thermosetting adhesive or pressure-sensitive adhesive layer, the stability with time of the thermosetting adhesive or pressure-sensitive adhesive layer is good. Also, since the plastic film substrate is used as the substrate of the release liner, there is no generation of a paper dust to be caused due to the release liner in the manufacturing or processing step. Furthermore, by forming the release layer as a layer made of low density polyethylene and having a specified thickness, it is possible to make both releasability and processability compatible with each other on high levels. For that reason, the thermosetting adhesive or pressure-sensitive adhesive tape or sheet of the invention is especially useful as a thermosetting adhesive or pressure-sensitive adhesive tape or sheet to be used in adhesion with respect to a flexible printing circuit board.

### DETAILED DESCRIPTION OF THE INVENTION

The thermosetting adhesive or pressure-sensitive adhesive tape or sheet of the invention has a structure in which a release liner (hereinafter sometimes referred to as "release liner of the invention") which has a release layer containing low density polyethylene (LDPE) as a major component and having a thickness of 5 µm or more and less than 20 µm on at least one side of a plastic film substrate is provided on at least one surface of a thermosetting adhesive or pressure-sensitive adhesive layer formed of a thermosetting adhesive or pressure-sensitive adhesive composition containing an acrylic polymer (X) constituted of, as essential monomer components, an alkyl (meth)acrylate (a) in which the alkyl moiety thereof has from 2 to 14 carbon atoms and a cyano group-containing monomer (b), and a phenol resin (Y) (this thermosetting adhesive or pressure-sensitive adhesive layer will be hereinafter sometimes referred to as "thermosetting adhesive or pressure-sensitive adhesive layer of the invention").

When the "thermosetting adhesive or pressure-sensitive adhesive tape or sheet" is referred to in the invention, it generally refers to one including a "release liner"; and the "residual portion of the thermosetting adhesive or pressure-sensitive adhesive tape or sheet from which the release liner has been released" is sometimes referred to as "adhesive or pressure-sensitive adhesive body portion". Also, the surface of the adhesive or pressure-sensitive adhesive layer of the adhesive or pressure-sensitive adhesive body portion is sometimes referred to as "adhesive surface". That is, the thermosetting adhesive or pressure-sensitive adhesive tape or sheet of the invention has a structure in which the adhesive or pressure-sensitive adhesive body portion including at least the thermosetting adhesive or pressure-sensitive adhesive layer of the invention and the release liner of the invention are laminated. A specific constitution of the adhesive or pressure-sensitive adhesive body portion is not particularly limited. The adhesive or pressure-sensitive adhesive body portion may be an "adhesive or pressure-sensitive adhesive body portion of a substrate-less type" including only a thermosetting adhesive or pressure-sensitive adhesive layer, or may be an "adhesive or pressure-sensitive adhesive body portion of a substrate-provided type" including a substrate and a thermosetting adhesive or pressure-sensitive adhesive layer provided on at least one side of the substrate.

### Release liner

The release liner of the invention is a release liner including a plastic film substrate (liner substrate) and a release layer provided on at least one side of the plastic film substrate, in which the release layer contains low density polyethylene as a major component and has a thickness of 5 µm or more and less than 20 µm (this release layer will be hereinafter sometimes referred to as "release layer of the invention"). The release liner does not substantially contain a silicone component because the release layer is constituted of low density polyethylene. Accordingly, even when an adherend is a precision electronic instrument such as a flexible printing circuit board (FPC), it is possible to prevent inconveniences to be caused due to transfer of the silicone component, such as contact fault, from occurring, and hence, such is preferable.

The substrate in the release liner of the invention (this substrate will be hereinafter sometimes referred to as "liner substrate") is a plastic film constituted of a polyester based resin such as polyethylene terephthalate (PET), polyethylene naphthalate (PEN) or polybutylene terephthalate (PBT); a polyolefin based resin containing, as a monomer component, an α-olefin such as for polyethylene (PE), polypropylene (PP), polymethyl pentene (PMP), an ethylene-propylene copolymer or an ethylene-vinyl acetate copolymer (EVA); polyvinyl chloride (PVC); a vinyl acetate based resin; polycarbonate (PC); polyphenylene sulfide (PPS); an amide based resin such as a polyamide (nylon) or a wholly aromatic polyamide (aramid); a polyimide based resin; a polyetheretherketone (PEEK); or the like. Above all, from the viewpoints of processability, availability and costs, a polyester based film is preferable, and a PET film is especially preferable. The use of a plastic film as the liner substrate is preferable because paper dusts in the manufacturing or processing step, which are generated in the case of using a paper based substrate, or fiber flocks which are generated in the case of a fiber based substrate and the like, are not generated.

Although the thickness of the plastic film which is the liner substrate is not particularly limited, it is preferably from 30 to 100 µm, more preferably from 30 to 75 µm, and further preferably from 35 to 60 µm. Since the plastic film has a relatively high stiffness as compared with a paper based substrate or the like, when the thickness exceeds 100 µm, repulsion properties become large, so that in the case where the thermosetting adhesive or pressure-sensitive adhesive tape or sheet is stored in a curved state, "floating" or "separation" of the release liner may be caused in some cases. On the other hand, when the thickness of the plastic film is less than 30 µm, since the nerve of the release liner disappears, the release of the release liner may become difficult so that the workability may be lowered in some cases.

The plastic film may be a single-layered film or a laminated film composed of the same resin layers or different resin layers. Also, the plastic film may be any of an unoriented (unstretched) film, a uniaxially oriented (uniaxially stretched) film or a biaxially oriented (biaxially stretched) film. From the viewpoint of thermal dimensional stability, the plastic film is preferably a biaxially oriented film.

The release layer of the invention is an essential release layer in the release liner of the invention. The release layer contains low density polyethylene (LDPE) as a major component, and the content of the low density polyethylene in the release layer is preferably 90% by weight or more, and more preferably 95% by weight or more relative to the total weight of the release layer. The release layer mainly formed of low density polyethylene has good releasability from the thermosetting adhesive or pressure-sensitive adhesive layer. For example, when middle density polyethylene (MDPE) is employed, since a release force is too high (heavy release), the release workability of the release liner is lowered, or the thermosetting adhesive or pressure-sensitive adhesive layer is separated during release. Thus, the middle density polyethylene is not preferable. On the other hand, when linear low density polyethylene (LLDPE) is employed, since a release force is too low (light release), falling-off of the release liner or "unintended separation" between the release liner and the thermosetting adhesive or pressure-sensitive adhesive layer is caused. Thus, the linear low density polyethylene is not preferable. The release layer of the invention may contain, in addition to the foregoing low density polyethylene, addition components as described later (various additives, etc.) so far as the addition amount thereof is less than 10% by weight.

The "low density polyethylene (LDPE)" as referred to in the invention means so-called "low density polyethylene" having a long-chain branch, which is obtained by polymerizing an ethylene monomer by a high-pressure process. In the invention, the "linear low density polyethylene (LLDE)" obtained by polymerizing ethylene and an α-olefin monomer having from 3 to 8 carbon atoms (for example, 1-hexene, 1-octene, etc.) by a low-pressure process (the length of the short-chain branch preferably has from 1 to 6 carbon atoms) is not included in LDPE.

The density (according to JIS K7112) of the low density polyethylene is preferably from 0.910 to 0.920 g/cm³. When the density of low density polyethylene is less than 0.910 g/cm³, there is a concern that the heat resistance is lowered or that the release force is lowered. On the other hand, when it exceeds 0.920 g/cm³, there is a concern that the release force becomes large.

The melt flow rate (MFR) at 200°C (according to JIS K7210) of the low density polyethylene is preferably from 4 to 15 g/10 min, and more preferably from 4 to 10 g/10 min.

As the low density polyethylene, only one kind thereof may be used, or a mixture of two or more kinds thereof may be used. Also, a commercially available product can be used. Examples thereof include SUNTEC LD, SUNTEC L1885 and SUNTEC L1850A, all of which are manufactured by ASAHI KASEI CORPORATION.

The thickness of the release layer of the invention is 5 µm or more and less than 20 µm, preferably from 8 to 18 µm, and more preferably from 10 to 15 µm. When the thickness of the release layer is less than 5 µm, it is difficult to achieve stable laminating. On the other hand, when it is 20 µm or more, the soft polyethylene layer becomes thick, so that in half-cutting or stamping of the thermosetting adhesive or pressure-sensitive adhesive tape or sheet, a "burr" (for example, a protrusion, a residual stock removal, etc.) is easily formed on the cut surface of the release liner, and processability is lowered.

The release layer (release layer containing LDPE as a major component) of the invention may be a single layer. So far as the characteristics of the invention are impaired, the release layer may be of a laminated structure in which two or more layers are laminated. In the case where the release layer of the invention is of a laminated structure, it is necessary that the thickness of the whole of the release layer (the whole of the laminated structure) is satisfied with the foregoing range.

A process for laminating the release layer on the liner substrate is not particularly limited, and a known laminating process or coating process can be adopted. Examples thereof include a heat laminating process, a coating process by heat-melt extrusion (extrusion laminating) and a co-extrusion process.

In particular, in the case where the release liner of the invention is used as a release liner of a single separator type as described later, the release liner may have a release layer other than the release layer of the invention (the former release layer will be hereinafter sometimes referred to as "other release layer"). Although the foregoing other release layer is not particularly limited, for example, a release layer containing linear low density polyethylene (LLDPE) as an essential constitutional component is preferable. The content of linear low density polyethylene in the other release layer is 50% by weight or more, and more preferably 70% by weight or more relative to the total weight of the other release layer. By providing the foregoing other release layer made of linear low density polyethylene on the back face of the release layer of the invention, the side of the other release layer is selectively released due to a difference in releasabilities between the both release layers (LLDPE is of light release). Therefore, not only the workability is enhanced, but the "unintended separation" can be prevented. Thus, such is preferable. In addition to the linear low density polyethylene, for example, an olefin based elastomer as described later may be added to the foregoing other release layer.

The thickness of the foregoing other release layer is not particularly limited. Similarly the release layer of the invention, from the viewpoints of laminating stability and processability, the thickness of the other release layer is preferably 5 µm or more and less than 20 µm.

From the viewpoint of making it easy to discriminate whether or not the release liner has been released, the release liner of the invention may be colored with a coloring agent (for examples, a pigment or a dye). Although the color to be colored is not particularly limited, a color which is easily distinguishable, namely a combination of a color of an adherend with a color with distinct contrast is preferable. For example, it is preferred to color the release liner of the invention white or black or the like.

In the foregoing case, examples of a process for coloring the release liner include a process for coloring the liner substrate or the release layer per se and a process for coloring the release liner by providing a printed layer (colored layer) by means of coating. In the case of coloring the liner substrate or the like, for example, a colored liner substrate can be obtained by adding a known or common coloring agent such as pigments (for example, various colorants exemplified in JP-A-2007-9137) to the raw material resin at the time of film fabrication. Examples of a process for adding the foregoing coloring agent include mixing of a pigment-containing raw material resin with a pellet with the same composition. Also, in the case of coating on the substrate, the release liner can be colored by coating a coating agent having a known or common coloring agent (for example, pigments, etc.) added thereto (for example, printing inks, etc.) on the liner substrate. As the coating process, a known or common process such as printing coating can be adopted, and, for example, a gravure printing system or the like can be adopted. Examples of the configuration of the release liner which has been, for example, colored white include a laminated structure including a liner substrate made of a white PET film and a release layer; and a laminated structure including a liner substrate made of a transparent PET film, a white printed layer and a release layer in this order.

The release liner of the invention may include an adhesive layer or the like, in addition to the foregoing liner substrate, release layer and printed player. Also, various additives such as a filler, a lubricant, an antiaging agent, an antioxidant, an ultraviolet absorber, a flame retardant and a stabilizer may be blended in each of the layers of the invention (for example, the liner substrate, the release layer, etc.) so far as the effects of the invention are not impaired.

### Thermosetting adhesive or pressure-sensitive adhesive layer

The thermosetting adhesive or pressure-sensitive adhesive layer in the thermosetting adhesive or pressure-sensitive adhesive tape or sheet of the invention is formed of a thermosetting adhesive or pressure-sensitive adhesive composition containing an acrylic polymer (X) constituted of, as essential monomer components, an alkyl (meth)acrylate (a) in which the alkyl moiety thereof has from 2 to 14 carbon atoms and a cyano group-containing monomer (b), and a phenol resin (Y). Herein, the alkyl (meth)acrylate (a) in which the alkyl moiety thereof has from 2 to 14 carbon atoms sometimes referred to as "C₂₋₁₄ alkyl (meth)acrylate (a)".

### Acrylic polymer (X)

The acrylic polymer (X) is composed of, as monomer components, at least a C₂₋₁₄ alkyl (meth)acrylate (a) and a cyano group-containing monomer (b). Furthermore, a carboxyl group-containing monomer (c) or other monomer component may be optionally used.

The C₂₋₁₄ alkyl (meth)acrylate (a) is not particularly limited so far as it is an alkyl (meth)acrylate (alkyl acrylate and/or alkyl methacrylate) having a linear or branched chain alkyl group having from 2 to 14 carbon atoms. Examples thereof include ethyl (meth)acrylate, propyl (meth)acrylate, isopropyl (meth)acrylate, n-butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate and tetradecyl (meth)acrylate. Of these, alkyl (meth)acrylates having from 4 to 12 carbon atoms are suitable. In particular, ethyl acrylate, n-butyl acrylate and 2-ethylhexyl acrylate can be suitably used.

The C₂₋₁₄ alkyl (meth)acrylate (a) may be used singly or in combinations of two or more kinds thereof.

In the invention, the C₂₋₁₄ alkyl (meth)acrylate (a) is used as a major component of monomers for constituting the acrylic polymer (X). From the viewpoint of adhesiveness, the proportion of the C₂₋₁₄ alkyl (meth)acrylate (a) is preferably from 60 to 80% by weight, and more preferably from 60 to 75% by weight relative to the total amount of monomer components.

The cyano group-containing monomer (b) is not particularly limited so far as it is a monomer containing a cyano group. Examples thereof include acrylonitrile and methacrylonitrile. As the cyano group-containing monomer (b), acrylonitrile can be suitably used. The cyano group-containing monomer (b) may be used singly or in combinations of two or more kinds thereof.

In the invention, the cyano group-containing monomer (b) is used for the purpose of improving the heat resistance or adhesiveness. For that reason, the proportion of the cyano group-containing monomer (b) is preferably from 20 to 35% by weight relative to the total amount of monomer components. When the proportion of the cyano group-containing monomer (b) is less than 20% by weight relative to the total amount of monomer components, the heat resistance becomes poor. Therefore, such is not preferable. On the other hand, when it exceeds 35% by weight, the flexibility is inferior. Therefore, such is not also preferable.

The carboxyl group-containing monomer (c) is not particularly limited so far as it is a monomer containing a carboxyl group. Examples thereof include (meth)acrylic acid (acrylic acid and/or methacrylic acid), itaconic acid, maleic acid, fumaric acid and crotonic acid. Also, acid anhydrides of these carboxyl group-containing monomers (for example, acid anhydride group-containing monomers such as maleic anhydride and itaconic anhydride) can be used as the carboxyl group-containing monomer (c). As the carboxyl group-containing monomer (c), acrylic acid, methacrylic acid and itaconic acid can be suitably used. The carboxyl group-containing monomer (c) may be used singly or in combinations of two or more kinds thereof.

In the invention, the carboxyl group-containing monomer (c) is optionally used for the purpose of improving the adhesiveness. For that reason, the proportion of the carboxyl group-containing monomer (c) is preferably not more than 10% by weight (for example, from 0.5 to 10% by weight) relative to the total amount of monomer components. When the proportion of the carboxyl group-containing monomer (c) exceeds 10% by weight relative to the total amount of monomer components, the flexibility is inferior, and therefore, such is not preferable.

Other monomer component (copolymerizable monomer), which is copolymerizable with the C₂₋₁₄ alkyl (meth)acrylate (a) or the cyano group-containing monomer (b) or the carboxyl group-containing monomer (c) which is optionally used, may be used as a monomer component constituting the acrylic polymer (X). Examples of such a copolymerizable monomer include methyl (meth)acrylate; C₁₅₋₂₀ alkyl (meth)acrylates such as pentadecyl (meth)acrylate, hexadecyl (meth)acrylate, heptadecyl (meth)acrylate, octadecyl (meth)acrylate, nonadecyl (meth)acrylate and eicosyl (meth)acrylate; non-aromatic ring-containing (meth)acrylates such as cycloalkyl (meth)acrylates (for example, cyclohexyl (meth)acrylate, etc.) and isobornyl (meth)acrylate; aromatic ring-containing (meth)acrylates such as aryl (meth)acrylates (for example, phenyl (meth)acrylate, etc.), aryloxyalkyl (meth)acrylates (for example, phenoxyethyl (meth)acrylate, etc.) and arylalkyl (meth)acrylates (for example, benzyl (meth)acrylate, etc.); epoxy group-containing acrylic monomers such as glycidyl (meth)acrylate and methylglycidyl (meth)acrylate; vinyl ester based monomers such as vinyl acetate and vinyl propionate; styrene based monomers such as styrene and α-methylstyrene; hydroxyl group-containing monomers such as hydroxyethyl (meth)acrylate, hydroxypropyl (meth)acrylate and hydroxybutyl (meth)acrylate; alkoxyalkyl (meth)acrylate based monomers such as methoxyethyl (meth)acrylate and ethoxyethyl (meth)acrylate; aminoalkyl (meth)acrylate based monomers such as aminoethyl (meth)acrylate, N,N-dimethylaminoethyl (meth)acrylate and t-butylaminoethyl (meth)acrylate; (N-substituted) amide based monomers such as (meth)acrylamide, N,N-dimethyl (meth)acrylamide, N-butyl (meth)acrylamide and N-hydroxy (meth)acrylamide; olefin based monomers such as ethylene, propylene, isoprene and butadiene; and vinyl ether based monomers such as methyl vinyl ether.

Also, polyfunctional monomers such as hexanediol di(meth)acrylate, butanediol di(meth)acrylate, (poly)ethylene glycol di(meth)acrylate, (poly)propylene glycol di(meth)acrylate, neopentyl glycol di(meth)acrylate, pentaerythritol di(meth)acrylate, glycerin di(meth)acrylate, trimethylolpropane tri(meth)acrylate, pentaerythritol tri(meth)acrylate, dipentaerythritol hexa(meth)acrylate, epoxy acrylate, polyester acrylate, urethane acrylate and divinylbenzene can be used as the copolymerizable monomer.

The acrylic based polymer (X) can be prepared by a known or common polymerization process (for example, a solution polymerization process, an emulsion polymerization process, a suspension polymerization process, a block polymerization process, a polymerization process upon irradiation of UV rays, etc).

A polymerization initiator, a chain transfer agent and so on, which are used in the polymerization of the acrylic polymer (X), are not particularly limited but can be properly selected and used among those which are known or common. More specifically, examples of the polymerization initiator include azo based polymerization initiators such as 2,2'-azobisisobutyronitrile, 2,2'-azobis(4-methoxy-2,4-dimethylvaleronitrile), 2,2'-azobis(2,4-dimethylvaleronitrile), 2,2'-azobis(2-methylbutyronitrile), 1,1' -azobis(cyclohexane-1-carbonitrile), 2,2'-azobis(2,4,4-trimethylpentane) and dimethyl-2,2'-azobis(2-methylpropionate); and peroxide based polymerization initiators such as benzoyl peroxide, t-butyl hydroperoxide, di-t-butyl peroxide, t-butyl peroxybenzoate, dicumyl peroxide, 1,1-bis(t-butylperoxy)-3,3,5-trimethylcyclohexane and 1,1-bis(t-butylperoxy)cyclododecane. The polymerization initiator can be used singly or in combinations of two or more kinds thereof. The amount of the polymerization initiator to be used can be properly selected within the range which is usually used.

Also, examples of the chain transfer agent include 2-mercaptoethanol, lauryl mercaptan, glycidyl mercaptan, mercaptoacetic acid, 2-ethylhexyl thioglycolate, 2,3-dimercapto-1-propanol and α-methylstyrene dimer.

In the solution polymerization, various general solvents can be used. Examples of such a solvent include organic solvents, for example, esters such as ethyl acetate and n-butyl acetate; aromatic hydrocarbons such as toluene and benzene; aliphatic hydrocarbons such as n-hexane and n-heptane; alicyclic hydrocarbons such as cyclohexane and methylcyclohexane; and ketones such as methyl ethyl ketone and methyl isobutyl ketone. The solvent can be used singly or in combinations of two or more kinds thereof.

The weight average molecular weight of the acrylic polymer (X) is not particularly limited. For example, the weight average molecular weight of the acrylic polymer (X) can be properly selected within the range of from 100,000 to 1,000,000 (preferably from 200,000 to 800,000). The weight average molecular weight of the acrylic polymer (X) can be controlled by the kinds and use amounts of the polymerization initiator and the chain transfer agent, the temperature and time of the polymerization and others such as the concentration of monomer and the dropping rate of monomer. The weight average molecular weight of the acrylic polymer (X) can be measured by, for example, gel permeation chromatography (GPC). On that occasion, the measurement conditions are not particularly limited but can be properly selected among known measurement conditions.

### Phenol resin (Y)

The phenol resin (Y) is not particularly limited so far as it is a phenol resin. The phenol resin (Y) can be properly selected and used among resol type phenol resins, novolak type phenol resins and various modified phenol resins (for example, alkyl-modified phenol resins, etc.). The phenol resin (Y) can be used singly or in combinations of two or more kinds thereof.

As the phenol resin (Y), resol type phenol resins are preferable. In particular, a carbolic acid based resol type phenol resin represented by the following formula (1) can be suitably used.

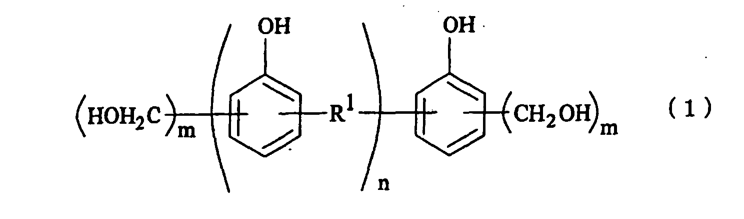

In the foregoing formula (1), R¹ represents -CH₂- or -CH₂-O-CH₂-. In addition, symbol "n" represents a positive integer, and although not particularly limited, it can be selected, for example, among integers in the range of from 1 to 20. Furthermore, symbol "m" represents an integer of from 1 to 4.

It is preferable that the carbolic acid based resol type phenol resin is in the liquid state or balsam state at 50°C.

The phenol resin (Y) is used for the purpose of imparting thermosetting property and heat resistance. The weight average molecular weight of the phenol resin (Y) is not particularly limited.

### Thermosetting adhesive or pressure-sensitive adhesive composition

The thermosetting adhesive or pressure-sensitive adhesive composition for forming the thermosetting adhesive or pressure-sensitive adhesive layer in the thermosetting adhesive or pressure-sensitive adhesive tape or sheet of the invention contains at least the acrylic polymer (X) and the phenol resin (Y). In the thermosetting adhesive or pressure-sensitive adhesive composition, with respect to the blending proportion of the acrylic polymer (X) and the phenol resin (Y), the proportion of the phenol resin (Y) is preferably from 1 to 20 parts by weight, and more preferably from 5 to 15 parts by weight based on 100 parts by weight of the acrylic polymer (X). When the proportion of the phenol resin (Y) is less than 1 part by weight based on 100 parts by weight of the acrylic polymer (X), there is a concern that the thermosetting property is insufficient. On the other hand, when it exceeds 20 parts by weight, there is a concern that the adhesive strength is lowered.

In the thermosetting adhesive or pressure-sensitive adhesive composition, in addition to the acrylic polymer (X) and the phenol resin (Y), known additives such as an antiaging agent, a filler, a coloring agent (for example, a pigment, a dye, etc.), an ultraviolet absorber, an antioxidant, a crosslinking agent, a tackifier, a plasticizer, a softener, a surfactant and an antistatic agent may be optionally incorporated within the range where the characteristics of the invention are not impaired.

The thermosetting adhesive or pressure-sensitive adhesive composition can be prepared by mixing the acrylic polymer (X) and the phenol resin (Y) and optionally, various additives (for example, an antiaging agent, a filler, a pigment, etc.) and so on.

The acrylic polymer (X) and the phenol resin (Y) can be used in the state of solution or dispersion. In the case where the acrylic polymer (X) is used in the solution state, a solvent is not particularly limited. For example, the solvent can be properly selected among the solvents exemplified as the solvent to be used for preparing the acrylic polymer (X) by solution polymerization. Also, in the case where the phenol resin (Y) is used in the solution state, a solvent is not particularly limited. For example, monohydric alcohols such as methanol, ethanol, propanol, isopropanol and butanol; polyhydric alcohols such as ethylene glycol; ketones; acetic esters; and ethers can be used.

In the thermosetting adhesive or pressure-sensitive adhesive tape or sheet of the invention, since the foregoing thermosetting adhesive or pressure-sensitive adhesive layer (the thermosetting adhesive or pressure-sensitive adhesive layer of the invention) is formed of the foregoing thermosetting adhesive or pressure-sensitive adhesive composition, it has a slight stickiness at the ambient temperature such that it can be stuck to an adherend and has an adhesiveness such that when heated, a setting reaction is generated to increase an adhesive strength, whereby it can be firmly adhered to the adherend with excellent heat resistance.

From the viewpoints of adhesiveness and processability, the thickness of the thermosetting adhesive or pressure-sensitive adhesive layer of the invention is preferably from 5 to 100 µm, more preferably from 10 to 50 µm, and further preferably from 20 to 40 µm. The thermosetting adhesive or pressure-sensitive adhesive layer may have any state of a single layer or a laminate.

### Thermosetting adhesive or pressure-sensitive adhesive tape or sheet

The thermosetting adhesive or pressure-sensitive adhesive tape or sheet of the invention includes at least the foregoing release liner (the release liner of the invention) and the adhesive or pressure-sensitive adhesive body portion containing the foregoing thermosetting adhesive or pressure-sensitive adhesive layer (the thermosetting adhesive or pressure-sensitive adhesive layer of the invention). Furthermore, the thermosetting adhesive or pressure-sensitive adhesive tape or sheet of the invention has at least a structure in which the release liner of the invention is laminated on at least one surface of the thermosetting adhesive or pressure-sensitive adhesive layer of the invention.

The adhesive or pressure-sensitive adhesive body portion may be an adhesive or pressure-sensitive adhesive body portion of a substrate-less type, which includes only the thermosetting adhesive or pressure-sensitive adhesive layer of the invention and which does not have a substrate; or may be an adhesive or pressure-sensitive adhesive body portion of a substrate-provided type, which includes a substrate and the thermosetting adhesive or pressure-sensitive adhesive layer of the invention provided on at least one side of the substrate. Above all, from the viewpoint of heat resistance, the adhesive or pressure-sensitive adhesive body portion is preferably an adhesive or pressure-sensitive adhesive body portion of a substrate-less type. Incidentally, from the viewpoint that the adhesive or pressure-sensitive adhesive body portion is used in applications for fixing adherends to each other, it is an adhesive or pressure-sensitive adhesive double coated body (adhesive or pressure-sensitive adhesive double coated tape) in which the each surface thereof is an adhesive surface.

In the case where the adhesive or pressure-sensitive adhesive body portion is a substrate-provided type, the substrate of the adhesive or pressure-sensitive adhesive body portion is not particularly limited. For example, appropriate thin sheet materials including plastic based substrates such as films or sheets made of various resins (for example, olefin based resins, polyester based resins, polyvinyl chloride based resins, vinyl acetate based resins, amide based resins, polyimide based resins, polyetheretherketone (PEEK), polyphenylene sulfide (PPS), etc.); foamed articles such as foamed sheet; and laminates thereof (for example, laminates of plastic films (or sheets) or laminates of a plastic based substrate and a foamed article) can be used. The thickness of the substrate is not particularly limited. For example, the thickness of the substrate is preferably from 10 to 500 µm, more preferably from 12 to 200 µm, and further preferably from 15 to 100 µm. The substrate may have a single-layered state or multilayered state. Also, if desired, the substrate may be subjected to various treatments such as a back face treatment, an antistatic treatment and an undercoating treatment.

In the case where the adhesive or pressure-sensitive adhesive body portion is a substrate-provided type, the thermosetting adhesive or pressure-sensitive adhesive layer of the invention may be formed on at least one surface of the substrate. The thermosetting adhesive or pressure-sensitive adhesive layer of the invention may be formed on the both surfaces of the substrate, or a known pressure-sensitive adhesive layer or adhesive layer or the like may be formed on the other surface of the substrate.

In the thermosetting adhesive or pressure-sensitive adhesive tape or sheet of the invention, at least one surface of the thermosetting adhesive or pressure-sensitive adhesive layer of the adhesive or pressure-sensitive adhesive body portion is protected by the release liner of the invention. The thermosetting adhesive or pressure-sensitive adhesive tape or sheet of the invention may be in a state (1) that one sheet of release liner is provided on each adhesive surface, and the respective adhesive surface are protected by the two sheets of release liners (double separator type), or may be in a state (2) that both adhesive surfaces are protected by one sheet of release liner in which each side of the release liner is a release surface (single separator type).

In the case where the thermosetting adhesive or pressure-sensitive adhesive tape or sheet of the invention is a double separator type in which both adhesive surfaces of the adhesive or pressure-sensitive adhesive body portion are protected by two sheets of release liners, although the release liners of the invention may be provided on both adhesive surfaces, from the viewpoints of selective releasability and prevention of "unintended separation", it is preferable that the release liner of the invention is provided on only one adhesive surface, whereas a release liner other than the release liner of the invention (this release liner will be hereinafter sometimes referred to as "other release liner") is provided on the other adhesive surface.

In the case where the thermosetting adhesive or pressure-sensitive adhesive tape or sheet of the invention is a double separator type, the release liner of the invention may be a release liner in which one surface thereof is a release surface, and a release liner having a release layer (the release layer of the invention) only on one side of a liner substrate can be used. Incidentally, it is necessary that the release liner of the invention is provided such that the surface of the release layer of the invention comes into contact with the adhesive surface of the thermosetting adhesive or pressure-sensitive adhesive layer of the invention.

In the case where the thermosetting adhesive or pressure-sensitive adhesive tape or sheet of the invention is a double separator type, the other release liner is not particularly limited, and a known and common release liner can be used. However, it is preferred to use a release liner which does not substantially contain a silicone component. Above all, a release liner having a release layer which is constituted so as to contain linear low density polyethylene (LLDPE) as an essential component is preferable. The use of such a release liner having such a release layer is preferable because a difference between a release force between the release liner of the invention and one adhesive surface and a release force between the other release liner and the other adhesive surface is generated, whereby one of the release liners is easily selectively released, and "unintended separation" can be inhibited. In the foregoing case, in general, the other release liner is of light release and is first released. That is, the other release liner is used for the adhesive surface (also referred to as "first adhesive surface") to be first used (stuck), and the release liner of the invention is used for the adhesive surface (also referred to as "second adhesive surface") to be later used (stuck).

The linear low density polyethylene (LLDPE) which is used in the release layer of the foregoing other release liner is linear polyethylene obtained by polymerizing ethylene and an α-olefin monomer having from 3 to 8 carbon atoms by a low-pressure process. The length of the short-chain branch preferably has from 1 to 6 carbon atoms. Also, the α-olefin monomer is preferably, for example, 1-hexene, 1-octene, etc. The density (according to JIS K7112) of the linear low density polyethylene is preferably from 0.90 to 0.92 g/cm³. Although the content of the linear low density polyethylene is not particularly limited, it is preferably from 20 to 100% by weight, more preferably from 40 to 100% by weight, further preferably from 50 to 100% by weight, even further preferably from 70 to 100% by weight, and most preferably from 90 to 100% by weight relative to the total weight of the release layer.

From the viewpoint of releasability, in addition to LLDPE, an olefin based elastomer may be added to the release layer of the foregoing other release liner. The olefin based elastomer is an α-olefin or a copolymer containing an α-olefin and is not particularly limited so far as it is a compound exhibiting elastomeric properties. Examples thereof include an ethylene-α-olefin copolymer, a propylene-α-olefin copolymer, an ethylene-propylene-diene copolymer, an ethylene-vinyl acetate copolymer, polybutene, polyisobutylene and polyethylene chloride. Above all, from the viewpoints of releasability and compatibility, an ethylene-α-olefin copolymer is especially preferable. In the invention, it is to be noted that an ethylene-α-olefin copolymer having a density of less than 0.90 g/cm³ (for example, 0.860 g/cm³ or more and less than 0.90 g/cm³) is included in the olefin based elastomer. Although the α-olefin component of the ethylene-α-olefin copolymer is not particularly limited, an α-olefin having from about 3 to 10 carbon atoms, such as propylene and butene, is preferable, and at least one α-olefin (comonomer) selected from the group consisting of propylene, butene-1, hexane-1, 4-methylpenene-1 and octene-1 can be used. Although the content of the olefin based elastomer is not particularly limited, it is preferably from 0 to 80% by weight, more preferably from 0 to 60% by weight, further preferably from 0 to 50% by weight, even further preferably from 0 to 30% by weight, and most preferably from 0 to 10% by weight relative to the total weight of the release layer.

Each of the foregoing LLDPE and olefin based elastomer may be used singly or in admixture of two or more kinds thereof. Also, commercially available products can be used for these materials. Examples of LLDPE include MORETEC 0628D, manufactured by PRIME POLYMER CO., LTD.; and examples of the olefin based elastomer include TAFMER P0180 and TAFMAR P0280G (ethylene-propylene copolymer), all of which are manufactured by MITSUI CHEMICALS, INC.

Although the thickness of the release layer of the forgoing other release liner is not particularly limited, from the viewpoint of productivity, it is preferably from 5 to 30 µm, and more preferably from 10 to 25 µm.

The release layer of the forgoing other release liner may be provided on, for example, a known and common liner substrate. As the liner substrate, for example, the same plastic films as those in the release liner of the invention are preferably used. That is, a release liner including a plastic film substrate and a release layer which contains linear low density polyethylene (LLDPE) as an essential component and is provided on one side of the plastic film substrate is preferably exemplified as the other release liner. The thickness of the liner substrate to be used in the other release liner is not particularly limited. However, since there may be the case where the liner substrate is used as backing paper during half-cutting, the thickness of the liner substrate is preferably from 30 to 100 µm, and more preferably from 30 to 75 µm.

Also, the same various additives described for those which are useful in the release liner of the invention may be blended in the foregoing other release liner within the range where the effects of the invention are not impaired.

In the case where the thermal adhesive or pressure-sensitive adhesive tape or sheet of the invention is a single separator type in which both adhesive surfaces of the adhesive or pressure-sensitive body portion are protected by one sheet of release liner in which each side of the release liner is a release surface, the release liner of the invention is a release liner in which each side thereof are a release surface, and release layers are provided on both sides of the liner substrate. In the foregoing release liner, the release layer of the invention may be provided on each side of the liner substrate. However, from the viewpoint of generating a difference between the release forces on the both release surfaces, it is preferable that the release layer of the invention is provided on one side of the liner substrate, whereas the foregoing "other release layer" is provided on the other side of the liner substrate. In the single separator type, it is necessary that the thermal adhesive or pressure-sensitive adhesive tape or sheet of the invention is provided such that the surface of the release layer of the invention comes into contact with the adhesive surface of the thermosetting adhesive or pressure-sensitive adhesive layer of the invention. Also, in the case of a single separator type, in general, the other release liner is of light release and is first released and used. For that reason, in the case of a single separator type, in general, the release surface on the side of the release layer of the invention is used for the adhesive surface (second adhesive surface) to be later used (stuck).

Examples of a preferred specific configuration of the thermosetting adhesive or pressure-sensitive adhesive tape or sheet of the invention include (1) a configuration in which the release liner of the invention (release layer of the invention/liner substrate) is provided on one adhesive surface of the adhesive or pressure-sensitive adhesive body portion (double-sided adhesive or pressure-sensitive adhesive body) including only the thermosetting adhesive or pressure-sensitive adhesive layer of the invention, and the other release liner (other release layer/liner substrate) is provided on the other adhesive surface of the adhesive or pressure-sensitive adhesive body portion; and (2) a configuration in which the release liner of the invention (release layer of the invention/liner substrate/other release layer) is provided on one adhesive surface of the adhesive or pressure-sensitive adhesive body portion (double-sided adhesive or pressure-sensitive adhesive body) including only the thermosetting adhesive or pressure-sensitive adhesive layer of the invention.

In the thermosetting adhesive or pressure-sensitive adhesive tape or sheet of the invention, although the release force (180°-release) between the thermosetting adhesive or pressure-sensitive adhesive layer of the invention and the release liner of the invention is not particularly limited, it is preferably from 0.2 to 0.6 N/50 mm, and more preferably from 0.3 to 0.5 N/50 mm. When the above-mentioned release force exceeds 0.6 N/50 mm, there is a concern that problems such as a lowering of the release workability and separation of the adhesive or pressure-sensitive adhesive layer at the time of release are caused. When the above-mentioned release force is less than 0.2 N/50 mm, there is a concern that problems such as falling-off of the release liner and "unintended separation" are caused. In general, the above-mentioned release force is a release force between the adhesive surface (second adhesive surface) and the release liner.

In the thermosetting adhesive or pressure-sensitive adhesive tape or sheet of the invention, the release force (180°-release) between the first adhesive surface and the release liner is not particularly limited. However, from the viewpoints of differentiating it from the release force on the second adhesive surface and preventing falling-off of the release liner and so on, the foregoing release force is preferably from 0.05 to 0.3 N/50 mm, and more preferably from 0.1 to 0.2 N/50 mm. In many cases, the foregoing release force is a release force between the other release liner and the adhesive surface in the double separator type and a release force between the other release layer and the adhesive surface in the single separator type, respectively. Also, a difference between the release force on the first adhesive surface and that on the second adhesive surface {(release force on the second adhesive surface) - (release force on the first adhesive surface)} is not particularly limited. However, from the viewpoints of an enhancement of the workability and so on, it is preferably from 0.05 to 0.3 N/50 mm, and more preferably from 0.1 to 0.3 N/50 mm.

The thermosetting adhesive or pressure-sensitive adhesive tape or sheet of the invention may be formed in the wound state in a roll form, or may be formed in the state that the sheet is laminated. That is, the thermosetting adhesive or pressure-sensitive adhesive tape or sheet of the invention can have the state in the sheet form, tape form, etc.

The thermosetting adhesive or pressure-sensitive adhesive tape or sheet may have other layers (for example, an interlayer, an undercoat layer, etc.) within the range where the effects of the invention are not impaired.

The thermosetting adhesive or pressure-sensitive adhesive tape or sheet of the invention can be manufactured according to usual manufacturing processes of adhesive or pressure-sensitive adhesive tapes or sheets. For example, in the case of a thermosetting adhesive or pressure-sensitive adhesive tape or sheet of a double separator type having an adhesive or pressure-sensitive adhesive body portion of a substrate-less type, it can be prepared by a process in which the foregoing thermosetting adhesive or pressure-sensitive adhesive composition is coated on the release surface of the release liner of the invention such that the thickness after drying becomes a prescribed thickness and then dried to form a thermosetting adhesive or pressure-sensitive adhesive layer, and the release surface of the other release liner is then superimposed on the surface of the thermosetting adhesive or pressure-sensitive adhesive layer. In the case of a single separator type, the thermosetting adhesive or pressure-sensitive adhesive tape or sheet can be prepared by a process in which after forming a thermosetting adhesive or pressure-sensitive adhesive layer in the same manner as described above, it is wound in the roll form, thereby making the release layer on the back side of the release liner come into contact with the surface of the thermosetting adhesive or pressure-sensitive adhesive layer.

In coating the thermosetting adhesive or pressure-sensitive adhesive composition, common coaters (for example, a gravure roll coater, a reverse roll coater, a kiss roll coater, a dip roll coater, a bar coater, a knife coater, a spray coater, etc.) can be used.

In the thermosetting adhesive or pressure-sensitive adhesive tape or sheet of the invention, since the thermosetting adhesive or pressure-sensitive adhesive layer is formed of the foregoing thermosetting adhesive or pressure-sensitive adhesive composition, it is excellent in the stability with time and has slight stickiness (slight tackiness). For that reason, it is excellent in the workability in positioning at the time of lamination, etc. Specifically, the thermosetting adhesive or pressure-sensitive adhesive tape or sheet can be subjected to temporary sticking at the ambient temperature. Moreover, on that occasion, since it can be easily subjected to re-sticking, its sticking work is very simple so that the thermosetting adhesive or pressure-sensitive adhesive tape or sheet is excellent in the sticking workability. Also, after the positioning by temporary sticking and the sticking by pressure-sensitive adhesion, by causing a setting reaction by heating, it is possible to adhere a stack resulting from sticking by pressure-sensitive adhesion with excellent adhesiveness. Accordingly, in sticking the thermosetting adhesive or pressure-sensitive adhesive tape or sheet of the invention to an adherend by temporary sticking before setting by heating, it can be stuck to the adherend upon pressure-sensitive adhesion by temporary sticking while utilizing its slight stickiness. Also, after sticking by pressure-sensitive adhesion, the thermosetting adhesive or pressure-sensitive adhesive tape or sheet is set by heating, whereby it can be firmly adhered to the adherend. Moreover, it can exert excellent heat resistance after thermosetting.

Furthermore, since a release liner using a plastic film substrate is used as the release liner for protecting the thermosetting adhesive or pressure-sensitive adhesive layer, in a manufacturing or processing step (for example, processing of half-cutting the release liner of the invention and the adhesive or pressure-sensitive adhesive body portion, etc.), a paper dust is not generated, and excellent workability and quality are revealed. Also, since the release liner of the invention has a release layer containing low density polyethylene, it exhibits appropriate releasability from the thermosetting adhesive or pressure-sensitive adhesive layer. Thus, good workability is revealed, and falling-out or "unintended separation" at the time of release of the release liner is not generated. Hence, such is preferable. Furthermore, the thickness of the release layer is thin, and a "burr" is not formed at the time of half-cutting or stamping. Thus, excellent processability is revealed. In addition, since the release liner does not substantially contain a silicone component, even when a precision electronic instrument such as flexible printing circuit boards (FPC) is used as an adherend, it is possible to prevent inconveniences such as contact fault from occurring. Also, contamination to be caused due to a silicone component does not occur.

The thermosetting adhesive or pressure-sensitive adhesive tape or sheet of the invention can be suitably used in adhesion in precision electronic instruments such as flexible printing circuit boards (FPC). The adhesion in precision electronic instruments such as FPC, as referred to herein, means, as described previously, adhesion in preparing a precision electronic instrument such as FPC, or adhesion in sticking a precision electronic instrument such as FPC onto a reinforcing plate.

### Examples

The invention is hereunder described in more detail with reference to the following Examples, but it should not be construed that the invention is limited to these Examples. The configuration of the release liner used in each of the Examples and Comparative Examples is shown in Table 1.

### Example 1

### (Thermosetting adhesive or pressure-sensitive adhesive composition)

100 parts by weight of an acrylic polymer (a copolymer of butyl acrylate (BA)/acrylonitrile (AN)/acrylic acid (AA) = 75/23/2 (weight ratio) having a weight average molecular weight of 600,000, manufactured by TORAY COATEX CO., LTD.) was dissolved in ethyl acetate, thereby preparing an ethyl acetate solution of the acrylic polymer (solids concentration: 40 % by weight).

To 100 parts by weight (solids content) of the foregoing ethyl acetate solution of the acrylic polymer, 10 parts by weight (solids content) of a resol type phenol resin (a trade name: SUMILITE RESIN PR-51283 (manufactured by SUMITOMO BAKELITE CO., LTD., weight average molecular weight: 550,000)) was added, and the mixture was stirred, thereby preparing a thermosetting adhesive or pressure-sensitive adhesive composition solution.

### (Release liner (for second adhesive surface))

As a liner substrate, a white polyethylene terephthalate (PET) film (a trade name: LUMIRROR E20 (manufactured by TORAY INDUSTRIES, INC.), having titanium oxide kneaded therein) having a thickness of 38 µm was used as shown in Table 1.

As a release layer, low density polyethylene (LDPE) (a trade name: L1885 (manufactured by ASAHI KASEI CORPORATION), density: 0.918 g/cm³) was used.

The foregoing resin was extrusion laminated in a thickness of 13 µm on one side of the foregoing liner substrate, thereby preparing a release liner including LDPE/white PET film (for second adhesive surface; the release liner of the invention).

### (Release liner (for first adhesive surface))

As a liner substrate, a transparent PET film (a trade name: LUMIRROR S10 (manufactured by TORAY INDUSTRIES, INC.)) having a thickness of 50 µm was used as shown in Table 1.

As a release layer, linear low density polyethylene (LLDPE) (a trade name: MORETEC 0628D (manufactured by PRIME POLYMER CO., LTD.), density: 0.916 g/cm³) was used.

The foregoing resin was extrusion laminated in a thickness of 20 µm on one side of the foregoing liner substrate, thereby preparing a release liner including LLDPE/transparent PET film (for first adhesive surface; the other release liner).

### (Thermosetting adhesive or pressure-sensitive adhesive sheet)

The foregoing thermosetting adhesive or pressure-sensitive adhesive composition solution was coated in a thickness after drying of 25 µm on the release layer of the release liner of the invention (for second adhesive surface) and then dried at 100 °C for 3 minutes, thereby forming a thermosetting adhesive or pressure-sensitive adhesive layer. Furthermore, the release layer of the foregoing other release liner (for first adhesive surface) was superimposed on the surface of the foregoing thermosetting adhesive or pressure-sensitive adhesive layer, thereby obtaining a thermosetting adhesive or pressure-sensitive adhesive sheet (double separator type).

### Example 2

### (Release liner (for second adhesive surface))

As a liner substrate, a transparent PET film (a trade name: LUMIRROR S10 (manufactured by TORAY INDUSTRIES, INC.)) having a thickness of 38 µm was used as shown in Table 1, and a white ink was gravure printed on one side of the liner substrate and then dried, thereby forming a white printed layer having a thickness of 1 µm.

As a release layer, low density polyethylene (LDPE) (a trade name: L1850A (manufactured by ASAHI KASEI CORPORATION), density: 0.918 g/cm³) was used.

The foregoing resin was extrusion laminated in a thickness of 13 µm on the white printed layer of the foregoing liner substrate, thereby preparing a release liner including LDPE/white printed film/transparent PET film (for second adhesive surface; the release liner of the invention).

### (Release liner (for first adhesive surface))

As a liner substrate, a transparent PET film (a trade name: LUMIRROR S 10 (manufactured by TORAY INDUSTRIES, INC.)) having a thickness of 38 µm was used as shown in Table 1.

As a release layer, a mixed resin (blend) of 100 parts by weight of LLDPE (a trade name: 0628D (manufactured by PRIME POLYMER CO., LTD.)) and 10 parts by weight of an ethylene-propylene copolymer (a trade name: P0180 (manufactured by MITSUI CHEMICALS, INC.), density: 0.88 g/cm³) was used.

The foregoing mixed resin was extrusion laminated in a thickness of 20 µm on one side of the foregoing liner substrate, thereby preparing a release liner including blend polymer of LLDPE and ethylene-propylene copolymer/transparent PET film (for first adhesive surface; the other release liner).

### (Thermosetting adhesive or pressure-sensitive adhesive sheet)

By using the same thermosetting adhesive or pressure-sensitive adhesive composition solution as in Example 1, a thermosetting adhesive or pressure-sensitive adhesive sheet (double separator type) was obtained in the same manner as in Example 1.

### Example 3

### (Release liner)

As a liner substrate, a transparent PET film (a trade name: LUMIRROR S 10 (manufactured by TORAY INDUSTRIES, INC.)) having a thickness of 50 µm was used as shown in Table 1.

As a release layer (for second adhesive surface), the LDPE as in the release layer of the release liner of the invention (for second adhesive surface) of Example 1 was used.

As a release layer (for first adhesive surface), the same LLPDE as in the release layer of the other release liner (for first adhesive surface) of Example 1 was used.

The release layer (for second adhesive surface) and the release layer (for first adhesive surface) were extrusion laminated on one side of the foregoing liner substrate and on the other side of the foregoing liner substrate, respectively in the same manner as in Example 1, thereby preparing a release liner (release liner of the invention) including LPDE/transparent PET film/LLDPE.

### (Thermosetting adhesive or pressure-sensitive adhesive sheet)

The same thermosetting adhesive or pressure-sensitive adhesive composition solution as in Example 1 was coated in a thickness after drying of 25 µm on the release layer (for second adhesive surface) of the release liner of the invention and dried at 100 °C for 3 minutes, thereby forming a thermosetting adhesive or pressure-sensitive adhesive layer. This was wound in the roll form, thereby making the release layer for the first adhesive surface of the release liner come into contact with the other surface of the thermosetting adhesive or pressure-sensitive adhesive layer. There was thus obtained a thermosetting adhesive or pressure-sensitive adhesive sheet (single separator type).

### Comparative Example 1

### (Release liner (for second adhesive surface))

As a liner substrate, a transparent PET film (a trade name: LUMIRROR S-10 (manufactured by TORAY INDUSTRIES, INC.)) having a thickness of 50 µm was used as shown in Table 1.

As a release layer, a mixed resin (blend) of 100 parts by weight of LLDPE (a trade name: 0628D (manufactured by PRIME POLYMER CO., LTD.)) and 10 parts by weight of an ethylene-propylene copolymer (a trade name: P0180 (manufactured by MITSUI CHEMICALS, INC.)) was used.

The foregoing resin of the release layer was extrusion laminated in a thickness of 20 µm on one side of the foregoing liner substrate, thereby preparing a release liner including blend polymer of LLDPE and ethylene-propylene copolymer/transparent PET film (for second adhesive surface).

### (Release liner (for first adhesive surface))

As a liner substrate, a transparent PET film (a trade name: LUMIRROR S-10 (manufactured by TORAY INDUSTRIES, INC.)) having a thickness of 50 µm was used as shown in Table 1.

As a release layer, the same mixed resin of LLDPE and an ethylene-propylene copolymer as in the release layer of the other release liner (for first adhesive surface) of Example 2 was used.

The foregoing resin of the release layer was laminated on one side of the foregoing liner substrate by means of extrusion laminating, thereby preparing a release liner including blend polymer of LLDPE and ethylene-propylene copolymer/transparent PET film (for first adhesive surface).

### (Thermosetting adhesive or pressure-sensitive adhesive sheet)

The same thermosetting adhesive or pressure-sensitive adhesive composition solution as in Example 1 was coated in a thickness after drying of 25 µm on the release layer of the release liner (for second adhesive surface) and then dried at 100 °C for 3 minutes in the same manner as in Example 1, thereby forming a thermosetting adhesive or pressure-sensitive adhesive layer. Furthermore, the release layer of the foregoing release liner (for first adhesive surface) was superimposed on the surface of the foregoing thermosetting adhesive or pressure-sensitive adhesive layer, thereby obtaining a thermosetting adhesive or pressure-sensitive adhesive sheet (double separator type).

### Comparative Example 2

A thermosetting adhesive or pressure-sensitive adhesive sheet (double separator type) was obtained in the same manner as in Comparative Example 1, except for changing the kind and addition amount of the ethylene-propylene copolymer to be used in the release layer of the release liner for each of the first adhesive surface and the second adhesive surface as shown in Table 1.

### Comparative Example 3

A thermosetting adhesive or pressure-sensitive adhesive sheet (double separator type) was obtained in the same manner as in Comparative Example 1, except for changing the release liner for each of the first adhesive surface and the second adhesive surface to the other release liner (for first adhesive surface) employed in Example 1 as shown in Table 1.

### Comparative Example 4

A thermosetting adhesive or pressure-sensitive adhesive sheet (double separator type) was obtained in the same manner as in Comparative Example 1, except for changing the release liner for each of the first adhesive surface and the second adhesive surface to a release paper (a trade name: LL-50N (manufactured by LINTEC CORPORATION)) in a form having middle density polyethylene (MDPE) laminated on a paper substrate.

### Evaluation

With respect to each of the thermosetting adhesive or pressure-sensitive adhesive sheets obtained in the Examples and Comparative Examples, the release force of the release liner and the processability were measured and evaluated according to the following measurement methods. The results are shown in Table 1.
(1) Release force of release liner:
A strip-shaped sheet specimen having a width of 50 mm and a length of 150 mm was cut out from each of the thermosetting adhesive or pressure-sensitive adhesive sheets obtained in the Examples and Comparative Examples and provided as a measurement sample.
So far as the double separator type is concerned, in the case of measuring the release force on the light release side (first adhesive surface), the measurement sample was used as it was; and in the case of measuring the release force on the heavy release side (second adhesive surface), the release liner on the light release side (first adhesive surface) was released, and a PET film having a thickness of 25 µm was stuck (lined) and provided as a measurement sample.
So far as the single separator type is concerned, in the case of measuring the release force on the second adhesive surface, a PET film having a thickness of 25 µm was stuck (lined) to the adhesive surface on the opposite side to the release liner side and provided as a measurement sample. In the case of measuring the release force on the first adhesive surface, after once releasing the release liner, the residue was stuck so as to make the release layer for the first adhesive surface come into contact with the thermosetting adhesive or pressure-sensitive adhesive layer (the adhesive surface on the side opposite to the release liner side was lined with a PET film having a thickness of 25 µm) and provided as a measurement sample.
An 180°-release test was carried out using a tensile tester in conformity with JIS Z0237, thereby measuring an 180°-peel strength (N/50 mm) of the release liner.
The measurement was carried out under a condition at a release angle of 180° and at a drawing rate of 300 mm/min in an atmosphere at 23°C and 50%, thereby calculating the release force. The test was repeated three times (average value) for each sample.
(2) Processability:
The release liner (single body) obtained in each of the Examples and Comparative Examples was stamped by a die set mold (blade size: 2 mm, clearance between upper blade and lower blade: 5 µm, speed: 30 shots/min; 3-t press), and a "burr" of the stamped cut surface was observed, thereby evaluating the processability (processing aptitude) according to the following evaluation criteria.
A: A burr was not observed at all or not substantially observed on the cut surface.
B: A burr was slightly observed on the cut surface.
C: A burr was considerably observed on the cut surface.

**Table 1**

| | Release liner (for second adhesive surface) | | | | | | | |
|---|---|---|---|---|---|---|---|---|
| | Liner substrate | | | Release layer (for second adhesive surface) | | | | |
| | Material | Thickness of substrate | Coloration | Thickness of release layer | Material | Name of manufacture and trade name | Density of polyethylene | Release force |
| | | (µm) | | (µm) | | | (g/cm³) | (N/50 mm) |
| Example 1 | PET film | 38 | Kneaded with titanium oxide | 13 | LDPE | "L1885" (ASAHI KASEI CORPORATION) | 0.918 | 0.4 |
| Example 2 | PET film | 38 | White printed | 13 | LDPE | "L1850A" (ASAHI KASEI CORPORATION | 0.918 | 0.4 |
| Example 3 | PET film | 50 | Not colored | 13 | LDPE | "L1885" (ASAHI KASEI CORPORATION) | 0.918 | 0.4 |
| Comparative Example 1 | PET film | 50 | Not colored | 20 | LLDPE/ ethylene-propylene copolymer (weight ratio: 100/10) | "0628D" (PRIME POLYMER CO., LTD.)/ P0180 (MITSUI CHEMICALS, INC.) | 0.916/ 0.88 | 0.1 |
| Comparative Example 2 | PET film | 50 | Not colored | 20 | LLDPE/ ethylene-propylene copolymer (weight ratio: 100/150) | "0628D" (PRIME POLYMER CO., LTD.)/ "P0280G" (MITSUI CHEMICALS, INC.) | 0.916/ 0.88 | 0.1 |
| Comparative Example 3 | PET film | 50 | Not colored | 20 | LLDPE | "0628D" (PRIME POLYMER CO., LTD.) | 0.916 | 0.1 |
| Comparative Example 4 | Wood-free paper | 50 g/m² (*1) | - | 25 | MDPE | - | 0.93 | 0.7 |

| | Release layer (for first adhesive surface) | | | | | Processability | | |
|---|---|---|---|---|---|---|---|---|
| Thickness of release layer | Material | Name of manufacture and trade name | Density of polyethylene | Release force | | | | |
| (µm) | | | (g/cm³) | (N/50 mm) | | | | |
| Example 1 | - | - | - | - | - | A | | |
| Example 2 | - | - | - | - | - | A | | |
| Example 3 | 18 | LLDPE | "0628D" (PRIME POLYMER CO., LTD.) | 0.916 | 0.1 | A | | |
| Comparative Example 1 | - | - | - | - | - | B | | |
| Comparative Example 2 | - | - | - | - | - | B | | |
| Comparative Example 3 | - | - | - | - | - | B | | |
| Comparative Example 4 | 25 | MDPE | - | 0.93 | 0.7 | C | | |

| | Release liner (for first adhesive surface) | | | | | | | |
|---|---|---|---|---|---|---|---|---|
| | Liner substrate | | Release layer | | | | | |
| | Material | Thickness of substrate | Thickness of release layer | Material | Name of manufacture and trade name | Density of polyethylene | Release force | |
| | | (µm) | (µm) | | | (g/cm³) | (N/50 mm) | |
| Example 1 | PET film | 50 | 20 | LLDPE | "0628D" (PRIME POLYMER CO., LTD.) | 0.916 | 0.1 | |
| Example 2 | PET film | 38 | 20 | LLDPE/ ethylene-propylene copolymer (weight ratio: 100/10) | "0628D" (PRIME POLYMER CO., LTD.)/ P0180 (MITSUI CHEMICALS, INC.) | 0.916/ 0.88 | 0.1 | |
| Example 3 | - | - | - | - | - | - | - | |
| Comparative Example 1 | PET film | 50 | 20 | LLDPE/ ethylene-propylene copolymer (weight ratio: 100/10) | "0628D" (PRIME POLYMER CO., LTD.)/ P0180 (MITSUI CHEMICALS, INC.) | 0.916/ 0.88 | 0.1 | |
| Comparative Example 2 | PET film | 50 | 20 | LLDPE/ ethylene-propylene copolymer (weight ratio: 100/10) | "0628D" (PRIME POLYMER CO., LTD.)/ P0280G (MITSUI CHEMICALS, INC.) | 0.916/ 0.88 | 0.1 | |
| Comparative Example 3 | PET film | 50 | 20 | LLDPE | "0628D" (PRIME POLYMER CO., LTD.) | 0.916 | 0.1 | |
| Comparative Example 4 | Wood-free paper | 50 g/m² (*1) | 25 | MDPE | - | 0.93 | 0.7 | |

| | | | | | | | | |
|---|---|---|---|---|---|---|---|---|
| (*1) The thickness of the substrate of Comparative Example 4 is expressed in terms of a basis weight (g/m²). | | | | | | | | |

As is clear from Table 1, the thermosetting adhesive or pressure-sensitive adhesive sheet of the invention falls within an appropriate range with respect to the release force on the second adhesive surface and has excellent processability (Examples). On the other hand, in the case of using LLDPE in the release layer of the release liner for the second adhesive surface, there was a problem that the release force on the second adhesive surface is too low (Comparative Examples 1 to 3). Also, in the case of using wood-free paper as the liner substrate, the processability was lowered, and furthermore, in the case where the release layer is made of MDPE, there was a problem that the release force was too large (Comparative Example 4).

While the present invention has been described in detail and with reference to specific embodiments thereof, it will be apparent to one skilled in the art that various changes and modifications can be made therein without departing from the scope thereof.

This application is based on Japanese patent application No. 2008-110630 filed on April 21, 2008, the entire contents thereof being hereby incorporated by reference.

Further, all references cited herein are incorporated in their entireties.

## Claims

1. A thermosetting adhesive or pressure-sensitive adhesive tape or sheet comprising:
a thermosetting adhesive or pressure-sensitive adhesive layer formed of a thermosetting adhesive or pressure-sensitive adhesive composition containing an acrylic polymer (X) constituted of, as essential monomer components, an alkyl (meth)acrylate (a) in which the alkyl moiety thereof has from 2 to 14 carbon atoms and a cyano group-containing monomer (b), and a phenol resin (Y); and
provided on at least one surface of the thermosetting adhesive or pressure-sensitive adhesive layer, a release liner comprising a plastic film substrate and a release layer provided on at least one side of the plastic film substrate, the release layer containing low density polyethylene as a major component and having a thickness of 5 µm or more and less than 20 µm.

2. The thermosetting adhesive or pressure-sensitive adhesive tape or sheet according to claim 1, wherein the low density polyethylene has a density of from 0.910 to 0.920 g/cm³.

3. The thermosetting adhesive or pressure-sensitive adhesive tape or sheet according to claim 1 or 2, which is a thermosetting adhesive or pressure-sensitive adhesive tape or sheet in which both surfaces of an adhesive or pressure-sensitive adhesive body portion are adhesive surfaces,
wherein a first release liner is provided on one adhesive surface and a second release liner is provided on the other adhesive surface, and
wherein at least one of the first and second release liners is the release liner according to claim 1 or 2.

4. The thermosetting adhesive or pressure-sensitive adhesive tape or sheet according to claim 3, which is a thermosetting adhesive or pressure-sensitive adhesive tape or sheet in which both surfaces of an adhesive or pressure-sensitive adhesive body portion are adhesive surfaces,
wherein a first release liner is provided on one adhesive surface and a second release liner is provided on the other adhesive surface, and
wherein one of the first and second release liners is the release liner according to claim 1 or 2, and the other one of the first and second release liners is a release liner comprising a release layer containing linear low density polyethylene as an essential component.

5. The thermosetting adhesive or pressure-sensitive adhesive tape or sheet according to claim 1 or 2, which is a thermosetting adhesive or pressure-sensitive adhesive tape or sheet in which both surfaces of an adhesive or pressure-sensitive adhesive body portion are adhesive surfaces,
wherein a release liner is provided only on one adhesive surface, and the release liner is the release liner according to claim 1 or 2 comprising release layers on both sides of the plastic film substrate.

6. The thermosetting adhesive or pressure-sensitive adhesive tape or sheet according to claim 5, wherein the release liner according to claim 1 or 2 comprises:
the plastic film substrate,
the release layer containing low density polyethylene as a major component and having a thickness of 5 µm or more and less than 20 µm, the release layer being provided on one side of the plastic film substrate; and
another release layer containing linear low density polyethylene as an essential component and being disposed on the other side of the plastic film substrate.

7. The thermosetting adhesive or pressure-sensitive adhesive tape or sheet according to any one of claims 1 to 6, wherein the release liner according to claim 1 or 2 is colored.

8. The thermosetting adhesive or pressure-sensitive adhesive tape or sheet according to any one of claims 1 to 7, which is for use in adhesion with respect to a flexible printing circuit board.
